# EUROPEAN PATENT APPLICATION

(11) **EP 3 514 824 A1**
(43) Date of publication of application: **24.07.2019**
(21) Application number: 17877377.6
(22) Date of filing: 29.12.2017
(51) Int. Cl.: H01L 21/67, H01L 21/673, B65D 85/90

(54) **DRYING BOX FOR STORING SOLAR CELL CHIPS**

(30) Priority: 17.11.2017 CN 201711148293
(71) Applicant: Miasolé Equipment Integration (Fujian) Co., Ltd., 362000 Quanzhou Fujian (CN)
(72) Inventor: HU, Chao, Quanzhou Fujian 362000 (CN); SUN, Hongxia, Quanzhou Fujian 362000 (CN); SHU, Yi, Quanzhou Fujian 362000 (CN); CHEN, Fan, Quanzhou Fujian 362000 (CN); PAN, Deng, Quanzhou Fujian 362000 (CN); ZHU, Pengjian, Quanzhou Fujian 362000 (CN); XU, Guojun, Quanzhou Fujian 362000 (CN); LONG, Wei, Quanzhou Fujian 362000 (CN)
(74) Representative: D'Halleweyn, Nele Veerle Trees Gertrudis
(86) International application number: PCT/CN2017/119658
(87) International publication number: WO 2019/095517

(57) **Abstract**

The present application discloses a drying box for storing solar cell chips including a box body (1). Within the box body (1) is installed a top cover (2) that is reversibly opened and divides an inner chamber of the box body (1) into a storage chamber (13) at a lower part and a temporary storage chamber (14) at an upper part, and a side wall of the temporary storage chamber (14) is provided with a purge hole (3). The drying box further includes a control cabinet (4) disposed at one end of the box body (1). The control cabinet (4) is provided with a central controller as well as a purge controller and a drive device (5) electrically connected to the central controller. An inlet end of the purge controller is connected to a gas source and an outlet end is connected to the purge hole (3) through a gas pipe. The drive device (5) is connected to the top cover (2). The present application can effectively reduce the contact time of the cell chips and the air, and reduce the amount of water absorbed by the cell chips from the air, so as to ensure the photoelectric conversion efficiency of the cell chips.

## Description

### Technical Field

The present application relates to a storage device, and particularly to a drying box for storing solar cell chips.

### Background

In recent years, flexible solar cells have developed rapidly, and the photoelectric conversion efficiency of cell chips has also been continuously improved, therefore it is also especially important to control the quality of products in the manufacturing process. Because the flexible solar cells are very sensitive to water vapor in the air, it is easy for the flexible solar cells to absorb moisture in the air when exposed to the air, resulting in a decrease in the conversion efficiency of the flexible solar cells, so the storage of the flexible solar cells is very important. At present, there is no special device for storing flexible solar cell chips in this field. Currently, an open plastic cassette is mostly used. Before the cassette is full, the cell chips are all directly exposed to a workshop environment, and the time for filling each cassette is different, from 4 minutes to 2 hours. Before the cassette is full, the cell chips are all exposed to the air. The longer the exposure time is, the more water is absorbed by the film layer of the solar cell chips, and thus the photoelectric conversion efficiency of the cell chips is reduced more severely. After the cassette is full, it is placed in a drying cabinet. Before the packaging, the open cassette is removed from the drying cabinet. The solar cell chips will be exposed again to the air and absorb the moisture in the air, which will affect the photoelectric conversion efficiency of the cell chips. Therefore, it is very important to invent a solar cell chip storage device that can isolate moisture in the air.

### Summary

The objective of the present application is to provide a drying box for storing solar cell chips in order to solve the technical problems in the prior art. The dry box can effectively reduce the contact time of the cell chips and the air and reduce the amount of water absorbed by the cell chips from the air, so as to ensure the photoelectric conversion efficiency of the cell chips.

The present application provides a drying box for storing solar cell chips, comprising a box body, wherein within the box body is installed a top cover that is reversibly opened, wherein the top cover divides an inner chamber of the box body into a storage chamber at a lower part and a temporary storage chamber at an upper part, and wherein a side wall of the temporary storage chamber is provided with a purge hole; and further comprising a control cabinet, the control cabinet being disposed at one end of the box body, wherein the control cabinet is provided with a central controller as well as a purge controller and a drive device that are electrically connected to the central controller, and wherein an inlet end of the purge controller is connected to a gas source and an outlet end is connected to the purge hole through a gas pipe, and wherein the drive device is connected to the top cover.

In the foregoing drying box for storing solar cell chips, preferably, the top cover is an opposite opening type structure comprising a first cover plate and a second cover plate that are arranged symmetrically, wherein long sides of the first cover plate and the second cover plate away from each other are both provided with a rotating shaft, and the first cover plate and the second cover plate are rotatably mounted in the box body respectively by means of the rotating shaft.

In the foregoing drying box for storing solar cell chips, preferably, the drive device is a servo motor, the number of the servo motors is two, the two servo motors being connected to the two rotating shafts, respectively.

In the foregoing drying box for storing solar cell chips, preferably, further comprising: a ventilation system, the ventilation system comprising a humidity sensor, an inlet hole, an outlet hole and a one-way exhaust valve, wherein the humidity sensor is provided on a side wall of the storage chamber and is electrically connected to the central controller, and wherein the inlet hole is disposed on a side wall of an upper portion of the storage chamber and the outlet hole is disposed on a side wall of a lower portion of the storage chamber, and wherein the inlet hole is connected to the purge controller through a gas pipe and the outlet hole is connected to the one-way exhaust valve through a gas pipe, the one-way exhaust valve being installed on the control cabinet.

In the foregoing drying box for storing solar cell chips, preferably, the purge controller is an electronically controlled valve.

In the foregoing drying box for storing solar cell chips, preferably, an inner wall of the storage chamber is provided with an anticollision layer.

In the foregoing drying box for storing solar cell chips, preferably, the anticollision layer is made of natural rubber material, soft PVC material or Polylon film material.

In the foregoing drying box for storing solar cell chips, preferably, an infrared counter is provided in the temporary storage chamber, the infrared counter being electrically connected to the central controller.

In the foregoing drying box for storing solar cell chips, preferably, the gas source is a nitrogen gas source.

Compared with the prior art, the present application provides a top cover that is reversibly opened on the box body. The storage chamber can be isolated from air when the top cover is in a closed state, thereby reducing the amount of water absorbed by the film layer of the solar cell chips in the storage chamber. The temporary storage chamber is used to store the solar cell chip temporarily. When the stored solar cell chips reaches a certain number, the top cover is reversibly opened under the driving of the drive device, and thus the temporarily stored solar cell chips fall into the storage chamber. Since nitrogen gas is continuously fed into the temporary storage chamber through the purge hole, the solar cell chips located in the temporary storage chamber are isolated from the air and would not absorb water from the air, thereby ensuring the photoelectric conversion efficiency.

### Brief Description of Drawings

FIG. 1 is a schematic diagram of the whole structure of the present application;
FIG. 2 is a top view of the present application;
FIG. 3 is a left side view of the present application cut in half.

Description of the reference signs: 1-box body, 2-top cover, 3-purge hole, 4-control cabinet, 5-drive device, 6-first cover plate, 7-second cover plate, 8-humidity sensor, 9-inlet hole, 10-outlet hole, 11-one-way exhaust valve, 12-anticollision layer, 13-storage chamber, 14- temporary storage chamber, 15-first through hole, 16-second through hole, 17-display screen, 18-solar cell chip.

### Detailed Description

Embodiments of the present application are described in detail below, and examples of the embodiments are shown in the accompanying drawings, wherein the same or similar numerals denote the same or similar elements or elements having the same or similar functions throughout. The embodiments described below with reference to the accompanying drawings are exemplary, and are only used to explain the present application but cannot be construed as limiting the present application.

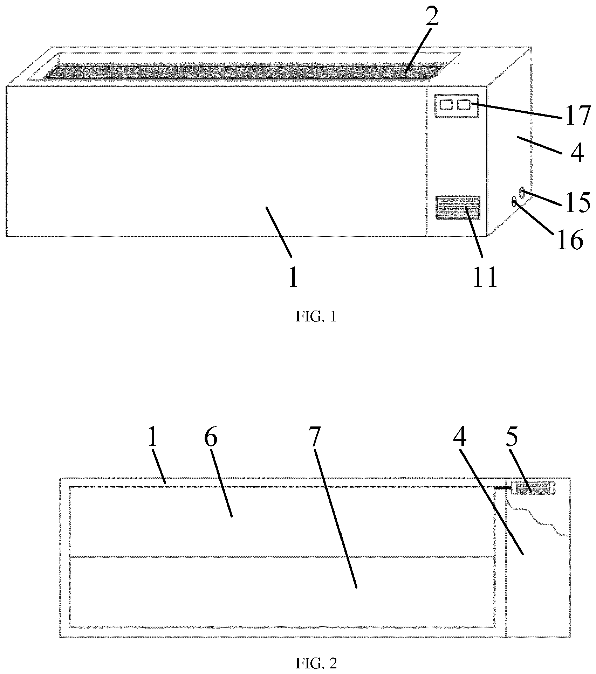

An Embodiment of the present application: as shown in FIG. 1 to FIG. 3, a drying box for storing solar cell chips includes a box body 1. The box body 1 is preferably made of stainless steel, and within the box body 1 is installed a top cover 2 that is reversibly opened. The top cover 2 divides the inner chamber of the box body 1 into a storage chamber 13 at the lower part and a temporary storage chamber 14 at the upper part. The side wall of the temporary storage chamber 14 is provided with a purge hole 3. The drying box also includes a control cabinet 4. The control cabinet 4 is disposed at one end of the box body 1 and forms an integrated structure with the box body 1. The control cabinet 4 is provided with a central controller (not shown in the figures), as well as a purge controller (not shown in the figures) and a driving device 5 that are electrically connected to the central controller. A side of the control cabinet 4 is provided with a first through hole 15 and a second through hole 16. The inlet end of the purge controller is connected to a gas pipe which passes through the first through hole 15 and is connected to a gas source (not shown in the figures). The outlet end of the purge controller is connected to the purge hole 3 through another gas pipe. The drive device 5 is connected to the top cover 2 for controlling the reversal of the top cover 2 so as to achieve opening and closing the box body 1. An end of a power cord with a plug on the central controller passes through the control cabinet 4 via the second through hole 16.

In operation, the power supply is connected, and the central controller controls the purge controller to turn on, so that the gas source continues to supply gas to the purge hole 3. Since the problem to be solved in the present application is how to reduce the amount of water absorbed by the solar cell chips from the air, the gas source is preferably a nitrogen gas source. That is to say, nitrogen gas is continuously sprayed from the purge hole 3, so that the temporary storage chamber 14 is filled with nitrogen gas. Thus, the solar cell chips 18 temporarily placed into the temporary storage chamber 14 are isolated from the air, and thereby won't absorb moisture in the air. After a preset number (for example, 5 pieces) of solar cell chips 18 is placed in the temporary storage chamber 14, the central controller controls the drive device 5 to drive the top cover 2 to reverse so that the temporary storage chamber 14 is in communication with the storage chamber 13, and the solar cell chips 18 automatically fall into the storage chamber 13 for storage, and then the central controller controls the drive device 5 to drive the top cover 2 to reverse so as to close the box body 1. At this point a working cycle is completed. A staff member continues to place solar cell chips 18 into the temporary storage chamber 14 and a next working cycle is started until the number (for example, 300 pieces) of solar cell chips 18 stored in the storage chamber 13 reaches a preset value.

The traditional way of working is to determine the number of already-stored solar cell chips 18 by manual counting in conjunction with the counting device of the whole production line, but this way will inevitably lead to errors. Therefore, in order to ensure the accuracy of the counting, an infrared counter (not shown in the figures) is preferably provided in the temporary storage chamber 14 and the infrared counter is electrically connected to the central controller. The control cabinet 4 is provided with a display screen 17 through which the quantity information collected by the central controller via the infrared counter is visually displayed to prevent errors.

It should be noted that the top cover 2 can be in a variety of structure forms, for example, single opening type, opposite opening type, or multiple opening type, as long as the structure can be automatically opened and closed. However, from the economical and practical point of view, an opposite opening type structure is preferred in this embodiment. Combined with FIG. 2, the top cover 2 is an opposite opening type structure including a first cover plate 6 and a second cover plate 7 that are arranged symmetrically, and the long sides of the first cover plate 6 and the second cover plate 7 away from each other are both provided with a rotating shaft. The first cover plate 6 and the second cover plate 7 are rotatably mounted in the box body 1 respectively by means of the rotating shaft. Since the present application is required to reduce the contact between the solar cell chips 18 and the air, the first cover plate 6 and the second cover plate 7 need to closely fit the box body 1 so as to ensure the airtightness and prevent the air from entering the box body 1 at a junction between the first cover plate 6 and the box body 1, at a junction between the second cover plate 7 and the box body 1, or through a gap between the first cover plate 6 and the second cover plate 7. The drive device 5 is preferably a servo motor, and there are two servo motors, which are respectively connected to the rotating shaft of the first cover plate 6 and the rotating shaft of the second cover plate 7.

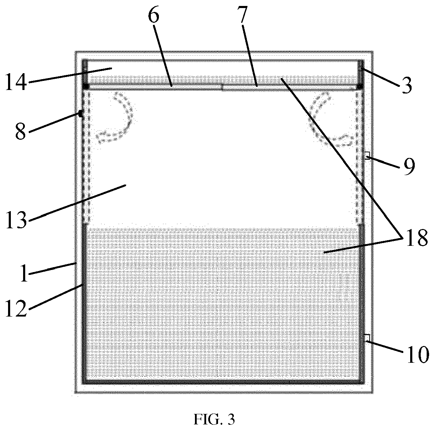

In operation, under the control of the central controller, the servo motors drive the first cover plate 6 and the second cover plate 7 to reverse. After the first cover plate 6 and the second cover plate 7 are reverse downward by 90 degrees in the directions of the arrows in FIG. 3, the temporary storage chamber 14 is in communication with the storage chamber 13, and then the servo motors are reversed, so that the first cover plate 6 and the second cover plate 7 are upwardly reversed to a horizontal state to achieve that the temporary storage chamber 14 is not in communication with the storage chamber 13. With such opposite opening type structure, the first cover plate 6 and the second cover plate 7 can occupy less space, so that the storage chamber 13 can store more solar cell chips, and the opposite opening type structure can be easily processed and manufactured.

Since a small amount of air enters the storage chamber 13 each time the top cover 2 is opened and closed, the solar cell chips 18 in the storage chamber 13 will absorb a small amount of moisture. In order to solve the problem, another embodiment is provided below.

On the basis of the above embodiment, as shown in FIGS. 1 and 3, a ventilation system is further included. The ventilation system includes a humidity sensor 8, an inlet hole 9, an outlet hole 10 and a one-way exhaust valve 11. The humidity sensor 8 is provided on a side wall of the storage chamber 13 and is electrically connected to the central controller. The inlet hole 9 is disposed on a side wall of the upper portion of the storage chamber 13, and the outlet hole 10 is disposed on a side wall of the lower portion of the storage chamber 13. The inlet hole 9 is connected to the purge controller through a gas pipe, and the outlet hole 10 is connected, through a gas pipe, to the one-way exhaust valve 11 which is installed on the control cabinet 4. The purge controller is an electronically controlled valve. The electronically controlled valve has at least one inlet and two outlets and the two outlets can be controlled independently, wherein one of the outlets connected to the purge hole 3 is always in an open state, and the other outlet connected to the inlet hole 9 is controlled to open or close based on the humidity information collected by the humidity sensor 8.

The specific way of operation is that: the humidity sensor 8 collects the humidity in the storage chamber 13 in real time. When the humidity value exceeds a preset value, the central controller controls the electronically controlled valve to open the outlet connected to the inlet hole 9 so that the gas source feeds nitrogen gas to the inlet hole 9 at the same time. The nitrogen gas enters the storage chamber 13 to force the air out of the storage chamber 13 through the outlet hole 10, and the air is discharged through the one-way exhaust valve 11. When the humidity value in the storage chamber 13 is below the set value, the central controller controls the electronically controlled valve to close the outlet connected to the inlet hole 9.

In another embodiment, as shown in FIG. 3, the inner wall of the storage chamber 13 has an anticollision layer 12. The anticollision layer 12 is made of natural rubber material, soft PVC material, or Polylon film material. Soft PVC material is preferably adopted in this embodiment. With the arrangement of the anticollision layer 12, it can effectively prevent the corners of solar cell chips 18 from being bended when falling, and it can also effectively prevent deformation caused by displacement during transportation.

The structure, features, and effects of the present application have been described in detail according to the embodiments shown in the drawings. The above depictions are only the preferred embodiments of the present application, but the present application does not limit the scope of implementation with that shown in the drawings. Changes based on the conception of the present application, or modifications into equivalent embodiments of the equivalent changes are within the scope of protection of the present application as long as they do not exceed the spirit covered by the description and the drawings.

### Industrial Applicability

The present application provides a drying box for storing solar cell chips. The storage chamber can be isolated from air by providing a top cover that is reversibly opened on the box body, thereby reducing the amount of water absorbed by the film layer of the solar cell chip in the storage chamber. The solar cell chips located in the storage chamber and the temporary storage chamber can be isolated from the air by continuously feeding nitrogen gas into the storage chamber and the temporary storage chamber through the purge hole, so as to further prevent the film layer from absorbing water in the air, thereby ensuring the photoelectric conversion efficiency of the solar cell chips. The present application is an urgently needed creation for today's industrialized society which is plagued by the problem of low photoelectric conversion efficiency of solar cell chips after absorbing moisture in the air. This application has strong industrial applicability.

## Claims

1. A drying box for storing solar cell chips, comprising a box body (1), wherein within the box body (1) is installed a top cover (2) that is reversibly opened, the top cover (2) divides an inner chamber of the box body (1) into a storage chamber (13) at a lower part and a temporary storage chamber (14) at an upper part, and a side wall of the temporary storage chamber (14) is provided with a purge hole (3); and further comprising a control cabinet (4), the control cabinet (4) being disposed at one end of the box body (1), wherein the control cabinet (4) is provided with a central controller as well as a purge controller and a drive device (5) that are electrically connected to the central controller, an inlet end of the purge controller is connected to a gas source and an outlet end is connected to the purge hole (3) through a gas pipe, and the drive device (5) is connected to the top cover (2).

2. The drying box for storing solar cell chips according to claim 1, wherein the top cover (2) is an opposite opening type structure comprising a first cover plate (6) and a second cover plate (7) that are arranged symmetrically, long sides of the first cover plate (6) and the second cover plate (7) away from each other are both provided with a rotating shaft, and the first cover plate (6) and the second cover plate (7) are rotatably mounted in the box body (1) respectively by means of the rotating shaft.

3. The drying box for storing solar cell chips according to claim 2, wherein the drive device (5) is a servo motor, the number of the servo motors is two, the two servo motors being connected to the two rotating shafts, respectively.

4. The drying box for storing solar cell chips according to claim 1, further comprising: a ventilation system, the ventilation system comprising a humidity sensor (8), an inlet hole (9), an outlet hole (10) and a one-way exhaust valve (11), wherein the humidity sensor (8) is provided on a side wall of the storage chamber (13) and is electrically connected to the central controller, and the inlet hole (9) is disposed on a side wall of an upper portion of the storage chamber (13), the outlet hole (10) is disposed on a side wall of a lower portion of the storage chamber (13), the inlet hole (9) is connected to the purge controller through a gas pipe and the outlet hole (10) is connected to the one-way exhaust valve (11) through a gas pipe, the one-way exhaust valve (11) being installed on the control cabinet (4).

5. The drying box for storing solar cell chips according to claim 1 or 4, wherein the purge controller is an electronically controlled valve.

6. The drying box for storing solar cell chips according to any one of claims 1-4, wherein an inner wall of the storage chamber (13) is provided with an anticollision layer (12).

7. The drying box for storing solar cell chips according to claim 6, wherein the anticollision layer (12) is made of natural rubber material, soft PVC material or Polylon film material.

8. The drying box for storing solar cell chips according to claim 6, wherein an infrared counter is provided in the temporary storage chamber (14), the infrared counter being electrically connected to the central controller.

9. The drying box for storing solar cell chips according to claim 1, wherein the gas source is a nitrogen gas source.
